# EUROPEAN PATENT APPLICATION

(11) **EP 4 411 838 A1**
(43) Date of publication of application: **07.08.2024**
(21) Application number: 21961186.0
(22) Date of filing: 18.11.2021
(51) Int. Cl.: H01L 31/18, H01L 31/068, H01L 31/0224

(54) **SOLAR CELL PREPARATION METHOD AND SOLAR CELL**

(30) Priority: 20.10.2021 CN 202111219995
(71) Applicant: Ja Solar Technology Yangzhou Co., Ltd., Yangzhou, Jiangsu 225131 (CN)
(72) Inventor: JIANG, Xiulin, Yangzhou, Jiangsu 225131 (CN); CHEN, Bin, Yangzhou, Jiangsu 225131 (CN); SHAN, Wei, Yangzhou, Jiangsu 225131 (CN)
(74) Representative: Sun, Yiming
(86) International application number: PCT/CN2021/131384
(87) International publication number: WO 2023/065447

(57) **Abstract**

The present disclosure discloses a preparation method for a solar cell and a solar cell. The preparation method for a solar cell comprises: locally forming a tunnel silicon oxide layer and an N-type doped polysilicon layer on a front surface of a P-type silicon substrate, wherein the N-type doped polysilicon layer is stacked on the tunnel silicon oxide layer; immersing the P-type silicon substrate having the tunnel silicon oxide layer and the N-type doped polysilicon layer locally formed on the front surface into an electroplating solution, irradiating the front surface of the P-type silicon substrate with light for a set duration so as to grow a front metal electrode on the N-type doped polysilicon layer, and removing a metal remaining on the front surface of the P-type silicon substrate by etching, wherein the width of the front metal electrode is the same as the width of the N-type doped polysilicon layer. The preparation method may omit an alignment operation in a metal electrode preparation process, thereby effectively reducing a difficulty in a preparation process of a local passivated contact emitter.

## Description

The disclosure claims priority to CN Patent Application No. 202111219995.7, entitled "Preparation Method for Solar Cell and Solar Cell", which was filed on October 20, 2021, and the contents of which are hereby incorporated by reference in its entirety to serve as all or part of the application.

### Technical Field

The disclosure relates to a preparation method for a solar cell and a solar cell.

### Background

TOPCon (Tunnel Oxide Passivated Contact) is tunnel oxide layer passivated contact solar cell technology based on the selective carrier principle, in which an ultra-thin layer of silicon oxide is prepared on the back surface of the cell, and then a thin layer doped silicon is deposited, the two layers together forming a passivated contact structure, which effectively reduces surface recombination and metal contact recombination. However, the thin layer doped silicon is mainly polysilicon, and the optical absorption coefficient of the polysilicon is larger than that of crystalline silicon, so the passivated contact structure is currently generally used on the back surface of the solar cell. If TOPCon is applied to the front surface of the solar cell, the light that hits the front surface of the crystalline silicon solar cell will be excessively absorbed in this layer of a polysilicon film, thereby significantly reducing light absorption of the crystalline silicon substrate as the absorbing layer.

When TOPCon is applied to the front surface of the solar cell, in order to eliminate parasitic absorption of light, a local passivated contact/emitter structure will be usually used, that is, a tunnel silicon oxide layer and a polysilicon film are deposited only in a metal gate line region, but are not deposited in other regions. At present, the preparation of the local passivated contact/emitter structure is mainly achieved by arranging a local tunnel oxide passivated layer and a local polysilicon layer on the surface of the silicon substrate in a mask manner, and preparing a front metal electrode in the region where the tunnel oxide passivated layer and the polysilicon layer are located by means of screen printing technology. During the preparation of the front metal electrode by means of the screen printing technology, it is required to achieve an alignment with the local tunnel oxide passivated layer and the local polysilicon layer. However, due to structural errors in the local tunnel oxide passivated layer and the local polysilicon layer arranged in the mask manner, it is difficult to achieve a precise alignment with screen printing, which results in a comparatively great difficulty in a preparation process of a local passivated contact em itter.

### Summary

In view of this, the technical problem to be solved by the disclosure lies in providing a preparation method for a solar cell and a solar cell, which may omit an alignment operation in a metal electrode preparation process, thereby effectively reducing a difficulty in a preparation process of a local passivated contact emitter.

In order to solve the aforesaid technical problem, the disclosure provides the following technical solutions:
According to a first aspect, the disclosure provides a preparation method for a solar cell, comprising:
step 101: locally forming a tunnel silicon oxide layer and an N-type doped polysilicon layer on a front surface of a P-type silicon substrate, wherein the N-type doped polysilicon layer is stacked on the tunnel silicon oxide layer;
step 102: immersing the P-type silicon substrate having the tunnel silicon oxide layer and the N-type doped polysilicon layer locally formed on the front surface into an electroplating solution, irradiating the front surface of the P-type silicon substrate with light for a set duration so as to grow a front metal electrode on the N-type doped polysilicon layer, and removing a metal remaining on the front surface of the P-type silicon substrate by etching, wherein the width of the front metal electrode is the same as the width of the N-type doped polysilicon layer.

According to a second aspect, the embodiment of the disclosure provides a solar cell, which is prepared by the preparation method provided according to the aforesaid first aspect.

The technical solution according to the aforesaid first aspect of the disclosure has the following advantages or beneficial effects: the preparation method for a solar cell provided by the embodiment of the disclosure may grow a metal electrode on a front N-type doped polysilicon layer by immersing the P-type silicon substrate having the tunnel silicon oxide layer and the N-type doped polysilicon layer locally formed on the front surface into an electroplating solution, and irradiating the front surface of the P-type silicon substrate with light for a set duration so as to grow a front metal electrode on the N-type doped polysilicon layer, that is, growing a front metal layer on the front N-type doped polysilicon layer using a light-induced electroplating method for the following reasons:
When a solar cell having a PN function formed on a P-type substrate is placed in the electroplating solution, and when the front N-type doped polysilicon layer is irradiated with light in an emitting region, due to the photovoltaic effect of the solar cell, the light-induced carriers are separated under the action of the built-in electric field. The electrons gather on the N-type doped polysilicon layer and diffuse to its surface, and the electrons are transferred to the metal ions in the electroplating solution. The metal ions are subjected to a reduction reaction on the N-type doped polysilicon layer, so a layer of metal is plated on the N-type doped polysilicon layer to form a metal electrode, that is, the N-type doped polysilicon layer in combination with the growth of the front metal electrode on the front N-type doped polysilicon layer using the light-induced electroplating method may achieve electronization of the front metal electrode in the growing process. A trace amount of metal grown on the P-type silicon substrate not covered by the tunnel silicon oxide layer and the N-type doped polysilicon layer may be removed using etch-back technology, so that the process of preparing the front metal electrode may not require an alignment of the tunnel silicon oxide layer and the N-type doped polysilicon layer that are locally formed, thereby effectively reducing a difficulty in a preparation process of a local passivated contact em itter.

In addition, since the N-type doped polysilicon layer in combination with the growth of the front metal electrode on the front N-type doped polysilicon layer using the light-induced electroplating method may achieve electronization of the front metal electrode in the growing process without an external electric field or an additional metal electrode seed layer, the process difficulty is further reduced, and the preparation method has simple steps and is easily implemented.

In addition, the tunnel silicon oxide layer and the N-type doped polysilicon layer in combination with the growth of the front metal electrode on the front N-type doped polysilicon layer using the light-induced electroplating method may make the width of the front metal electrode be the same as the width of the N-type doped polysilicon layer, and may effectively avoid a loss of a short-circuit current Isc and increase an open circuit voltage Voc, so the solar cell provided by the embodiment of the disclosure may effectively increase the efficiency of the solar cell.

In addition, the front metal grown on the front N-type doped polysilicon layer using the light-induced electroplating method has the same width as the N-type doped polysilicon layer, which may reduce the series resistance of the solar cell where it is located and increase the fill factor of the solar cell, thereby further increasing the efficiency of the solar cell.

### Brief Description of the Drawings

FIG. 1 is a schematic diagram of a flow of a preparation method for a solar cell according to the disclosure;
FIG. 2 is a schematic diagram of a structure of growing a tunnel silicon oxide layer on a front surface of a P-type silicon substrate according to the disclosure;
FIG. 3 is a schematic diagram of a structure of forming an N-type doped polysilicon layer on the tunnel silicon oxide layer according to the disclosure;
FIG. 4 is a schematic diagram of a structure of covering a patterned mask on the N-type doped polysilicon layer according to the disclosure;
FIG. 5 is a schematic plan view of the patterned mask according to the disclosure;
FIG. 6 is a schematic diagram of a structure after removing the N-type doped polysilicon layer in a region not covered by the mask according to the disclosure;
FIG. 7 is a schematic diagram of a structure after removing the tunnel silicon oxide layer in the region not covered by the mask and the mask according to the disclosure;
FIG. 8 is a schematic diagram of a metallized structure of a local passivated contact emitter according to the disclosure;
FIG. 9 is a schematic diagram of the metallized structure, which is a copper electrode, of the local passivated contact emitter according to the disclosure;
FIG. 10 is a schematic diagram of the metallized structure, which is a silver electrode, of the local passivated contact emitter according to the disclosure;
FIG. 11 is a schematic diagram of a flow of growing a front metal electrode on a front N-type doped polysilicon layer according to the disclosure;
FIG. 12 is a schematic diagram of the metallized structure, which is a nickel electrode and a copper electrode, of the local passivated contact emitter according to the disclosure;
FIG. 13 is a schematic diagram of the metallized structure, which is a nickel electrode and a silver electrode, of the local passivated contact emitter according to the disclosure;
FIG. 14 is a schematic diagram of a flow of growing the front metal electrode on the front N-type doped polysilicon layer according to the disclosure;
FIG. 15 is a schematic diagram of the metallized structure, which is a nickel electrode, a copper electrode and a silver electrode, of the local passivated contact emitter according to the disclosure;
FIG. 16 is a schematic diagram of a structure of forming a P+-type doped layer on the back surface of the structure shown in FIG. 8 according to the disclosure;
FIG. 17 is a schematic diagram of a structure of forming the P+-type doped layer on the back surface of the structure shown in FIG. 9 according to the disclosure;
FIG. 18 is a schematic diagram of a structure of forming the P+-type doped layer on the back surface of the structure shown in FIG. 10 according to the disclosure;
FIG. 19 is a schematic diagram of a structure of forming the P+-type doped layer on the back surface of the structure shown in FIG. 12 according to the disclosure;
FIG. 20 is a schematic diagram of a structure of forming the P+-type doped layer on the back surface of the structure shown in FIG. 13 according to the disclosure;
FIG. 21 is a schematic diagram of a structure of forming the P+-type doped layer on the back surface of the structure shown in FIG. 15 according to the disclosure;
FIG. 22 is a schematic diagram of a structure of sequentially forming the tunnel silicon oxide layer and a P-type doped polysilicon layer on the back surface of structure shown in FIG. 8 according to the disclosure;
FIG. 23 is a schematic diagram of a structure of sequentially forming the tunnel silicon oxide layer and the P-type doped polysilicon layer on the back surface of structure shown in FIG. 9 according to the disclosure;
FIG. 24 is a schematic diagram of a structure of sequentially forming the tunnel silicon oxide layer and the P-type doped polysilicon layer on the back surface of structure shown in FIG. 10 according to the disclosure;
FIG. 25 is a schematic diagram of a structure of sequentially forming the tunnel silicon oxide layer and the P-type doped polysilicon layer on the back surface of structure shown in FIG. 12 according to the disclosure;
FIG. 26 is a schematic diagram of a structure of sequentially forming the tunnel silicon oxide layer and the P-type doped polysilicon layer on the back surface of structure shown in FIG. 13 according to the disclosure;
FIG. 27 is a schematic diagram of a structure of sequentially forming the tunnel silicon oxide layer and the P-type doped polysilicon layer on the back surface of structure shown in FIG. 15 according to the disclosure;
FIG. 28 is a schematic diagram of a structure of forming a back metal electrode on the structure shown in FIG. 16 according to the disclosure;
FIG. 29 is a schematic diagram of a structure of forming the back metal electrode on the structure shown in FIG. 17 according to the disclosure;
FIG. 30 is a schematic diagram of a structure of forming the back metal electrode on the structure shown in FIG. 18 according to the disclosure;
FIG. 31 is a schematic diagram of a structure of forming the back metal electrode on the structure shown in FIG. 19 according to the disclosure;
FIG. 32 is a schematic diagram of a structure of forming the back metal electrode on the structure shown in FIG. 20 according to the disclosure;
FIG. 33 is a schematic diagram of a structure of forming the back metal electrode on the structure shown in FIG. 21 according to the disclosure;
FIG. 34 is a schematic diagram of a structure of forming the back metal electrode on the structure shown in FIG. 22 according to the disclosure;
FIG. 35 is a schematic diagram of a structure of forming the back metal electrode on the structure shown in FIG. 23 according to the disclosure;
FIG. 36 is a schematic diagram of a structure of forming the back metal electrode on the structure shown in FIG. 24 according to the disclosure;
FIG. 37 is a schematic diagram of a structure of forming the back metal electrode on the structure shown in FIG. 25 according to the disclosure;
FIG. 38 is a schematic diagram of a structure of forming the back metal electrode on the structure shown in FIG. 26 according to the disclosure; and
FIG. 39 is a schematic diagram of a structure of forming the back metal electrode on the structure shown in FIG. 27 according to the disclosure.

Reference signs are as follows:
10-P-type silicon substrate; 20-tunnel silicon oxide layer; 30-N-type doped polysilicon layer; 40-front metal layer; 41-metal nickel electrode; 42-metal copper electrode; 43-metal silver electrode; 50-mask; 60-P+-type doped layer; 70-P-type doped polysilicon layer; 80-back electrode.

### Detailed Description

When the TOPCon (Tunnel Oxide Passivated Contact) technology is applied to the front surface of the cell, in order to eliminate parasitic absorption of light, a local passivated contact/emitter structure will be usually used, that is, a tunnel silicon oxide layer and a polysilicon film are deposited only in a region where a metal gate line (a metal electrode) is located, but are not deposited in other regions, which brings a problem of how to make a localized (also called patterned) passivated contact/emitter structure. At present, the first solution to make the localized passivated contact/emitter structure that is commonly used is to use a photoetching manner, and although it can achieve perfect patterning, the disadvantage is that it is very expensive and is not suitable for industrialization. The second solution to make the localized passivated contact/emitter structure is to make patterned tunnel silicon oxide and polysilicon layers using a masking agent, and then prepare the metal electrode on the polysilicon layer using a screen printing process. The advantage of the second solution is that it is suitable for industrialization, but the disadvantage is that it is hard to achieve fine patterning, and in the process of preparing the metal electrode using the screen printing process, due to the working principle of the screen printing process and the errors in patterning, it is required to perform a secondary alignment of the patterned polysilicon layer with screen printing, which increases the process difficulty. In addition, making the metal electrode by means of the screen printing also requires an assistance of an external electric field, which increases the preparation steps and the preparation cost.

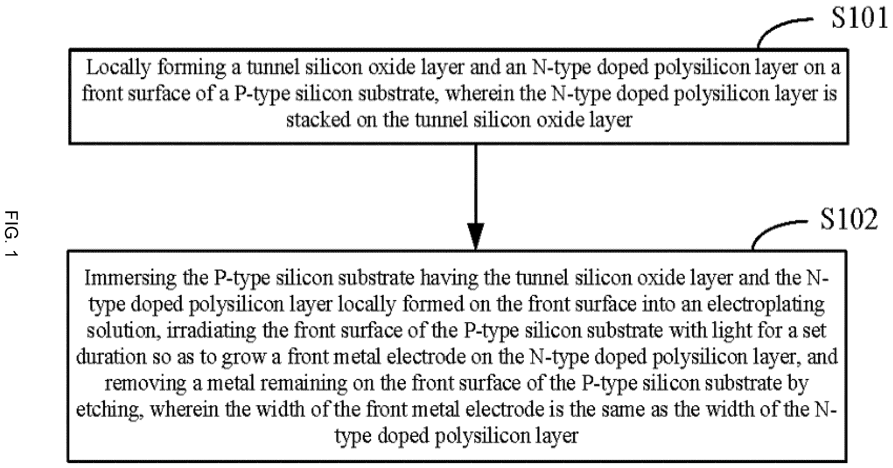

In order to solve the above problem existing in the process of preparing the metal electrode, the embodiment of the disclosure provides a preparation method for a solar cell. FIG. 1 is a schematic diagram of a main flow of a preparation method for a solar cell. As shown in FIG. 1, the preparation method for a solar cell may comprise the following steps:
step S101: locally forming a tunnel silicon oxide layer and an N-type doped polysilicon layer on a front surface of a P-type silicon substrate, wherein the N-type doped polysilicon layer is stacked on the tunnel silicon oxide layer;

Wherein the front surface of the P-type silicon substrate refers to the surface of the P-type silicon substrate facing towards the sunlight after the P-type silicon substrate is used to manufacture a solar cell, that is, the light-receiving surface of the P-type silicon substrate that receives sunlight, and on the contrary, the back surface of the P-type silicon substrate refers to the surface facing away from the sunlight, that is, the backlit surface opposite to the light-receiving surface of the P-type silicon substrate.

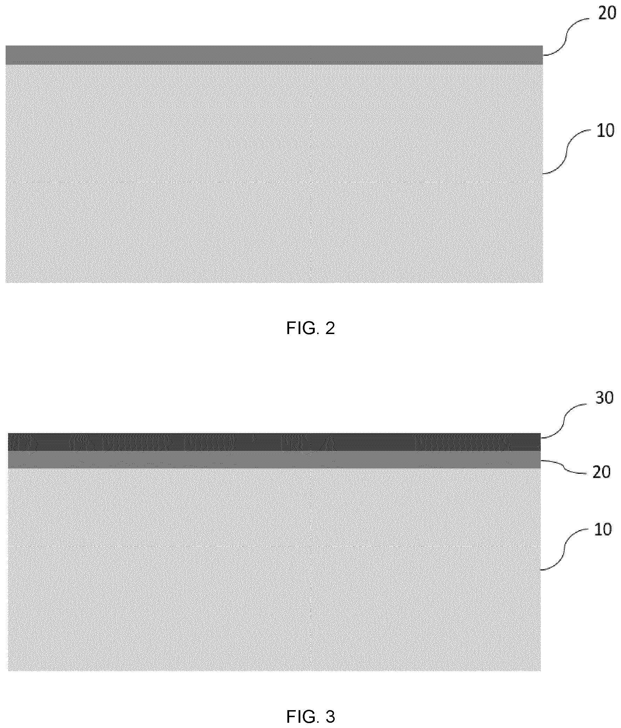

With respect to the step S101, the specific implementation scheme may comprise:
First, an entire tunnel silicon oxide layer 20 is formed on the front surface of the P-type silicon substrate 10. The thickness of the tunnel silicon oxide layer 20 may be an arbitrary value in a range of 0.5-2 nm, such as 0.5 nm, 0.7 nm, 0.9 nm, 1 nm, 1.2 nm, 1.5 nm, 1.8 nm, 2 nm, etc. In an optional embodiment, the width of the tunnel silicon oxide layer 20 is an arbitrary value in a range of 5-30 µm. In an optional embodiment, the width of the tunnel silicon oxide layer 20 is an arbitrary value in a range of 5-20 µm. The thickness and width ranges can effectively reduce the lateral resistance and the light-shielding property of the tunnel silicon oxide layer 20 while ensuring that the preparation process for a solar cell is comparatively simple. Wherein, FIG. 2 shows a schematic diagram of a structure of growing a tunnel silicon oxide layer on a front surface of a P-type silicon substrate.

Then, an entire N-doped polysilicon layer 30 is formed on the tunnel silicon oxide layer 20 grown on the front surface, wherein the width of the N-type doped polysilicon layer 30 is the same as the width of the tunnel silicon oxide layer 20, which can effectively reduce the lateral resistance and the light-shielding property of the N-doped polysilicon layer 30 while further ensuring that the preparation process for a solar cell is comparatively simple. Wherein, FIG. 3 shows a schematic diagram of a structure of forming an N-type doped polysilicon layer on the tunnel silicon oxide layer.

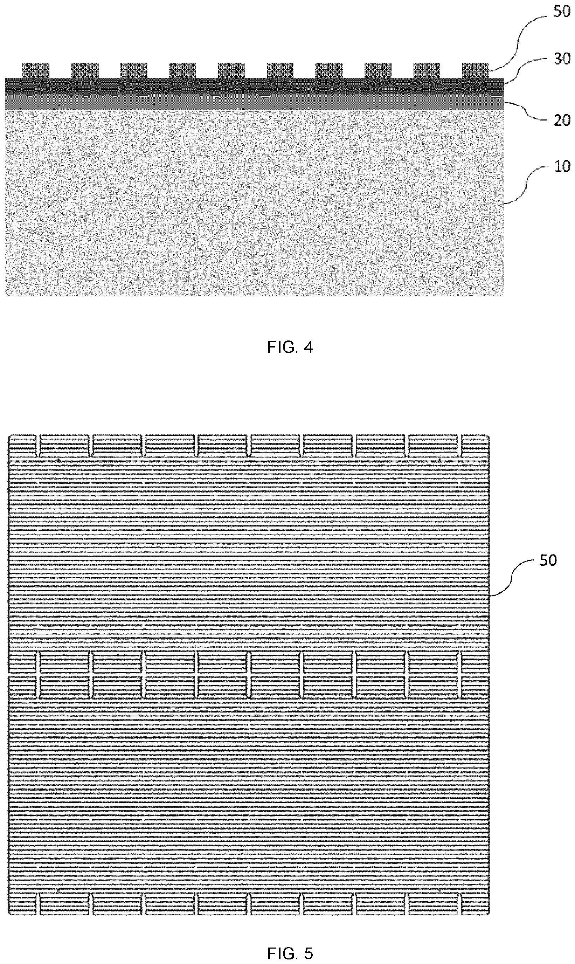

Further, a patterned mask 50 is arranged on the N-type doped polysilicon layer 30, and the mask 50 may include: any one of an SiOₓ film, an SiNₓ film and an SiON film. A schematic diagram of a structure of covering the patterned mask 50 on the N-type doped polysilicon layer 30 may be as shown in FIG. 4; a schematic plan view of the patterned mask 50 may be as shown in FIG. 5. As shown in FIG. 4, the patterned masks 50 are spaced apart from each other, and the distance between the tunnel silicon oxide layers 20 and the distance between the N-type doped polysilicon layers 30 may be controlled by controlling the distance between the patterned masks 50. Where the distance between the tunnel silicon oxide layers 20 refers to the distance between adjacent side surfaces of two adjacent tunnel silicon oxide layers 20; the distance between the N-type doped polysilicon layers 30 refers to the distance between adjacent side surfaces of two adjacent N-type doped polysilicon layers 30; correspondingly, the distance between metal electrodes 40 mentioned later refers to the distance between adjacent side surfaces of two adjacent metal electrodes 40.

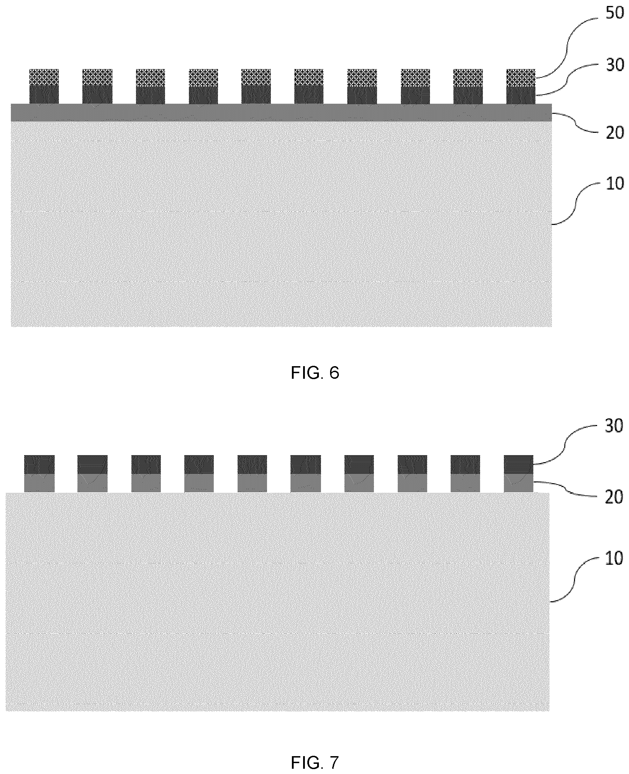

Then, the N-type doped polysilicon layer 30 in a region not covered by the mask 50 is removed using an alkali solution. FIG. 6 shows a schematic diagram of a structure after removing the N-type doped polysilicon layer 30 in a region not covered by the mask 50. After the N-type doped polysilicon layer 30 in the region not covered by the mask 50 is removed, the width of the left N-type doped polysilicon layer 30 in a region covered by the mask 50 may be 5-50 µm, such as 5 µm, 10 µm, 12 µm, 15 µm, 17 µm, 20 µm, 25 µm, 28 µm, 30 µm, 35 µm, 40 µm, 45 µm, 50 µm, etc.

The alkali solution is generally a KOH solution, a NaOH solution, and so on, and the concentration and action time thereof may be adjusted according to actual requirements. For example, the KOH solution may be selected, wherein the ratio of KOH to deionized water is 3:11, the corrosion time is 5min, and the corrosion temperature is 70°C.

After the N-type doped polysilicon layer in the region not covered by the mask 50 is corroded, the tunnel silicon oxide layer 20 in the region not covered by the mask 50 is removed, and the mask 50 is removed at the same time using an acid solution, wherein FIG. 7 shows a schematic diagram of a structure after removing the tunnel silicon oxide layer 20 in the region not covered by the mask 50 and the mask 50. After the tunnel silicon oxide layer 20 in the region not covered by the mask 50 is removed, the width of the tunnel silicon oxide layer 20 is the same as the width of the aforesaid N-type doped polysilicon layer 30.

The acid solution is generally an HF solution, and the concentration and corrosion time of the HF solution may be adjusted according to actual requirements. For example, the ratio of HF to deionized water in the HF solution is 2:3, the corrosion time is greater than or equal to 10 seconds, and the corrosion temperature is the room temperature.

step S102: immersing the P-type silicon substrate having the tunnel silicon oxide layer and the N-type doped polysilicon layer locally formed on the front surface into an electroplating solution, irradiating the front surface of the P-type silicon substrate with light for a set duration so as to grow a front metal electrode on the front N-type doped polysilicon layer, and removing a metal remaining on the front surface of the P-type silicon substrate by etching, wherein the width of the front metal electrode is the same as the width of the N-type doped polysilicon layer.

When the P-type silicon substrate 10 is immersed into the electroplating solution, and the front surface of the P-type silicon substrate is irradiated with light for a set duration, due to the photovoltaic effect of the solar cell, the light-induced carriers are separated under the action of the built-in electric field, wherein the electrons gather on the N-type doped polysilicon layer and diffuse to its surface, and the metal ions in the electroplating solution are subjected to a reduction reaction to form metal atoms by the electrons gathered on the surface of the N-type doped polysilicon layer and are deposited on the upper surface of the N-type doped polysilicon layer, so a layer of metal is plated on the N-type doped polysilicon layer to form a metal electrode.

Thus, the set duration of the light irradiation may be on a millisecond level, a second level, or the like. The specific set duration may be determined based on the concentration of metal ions included in the electroplating solution, the thickness of the metal electrode, and other parameters.

When the metal layer is grown on the upper surface of the N-type doped polysilicon layer by means of the light-induced electroplating method, a small amount of metal will also remain on the exposed P-type silicon substrate not covered by the N-type doped polysilicon layer and the tunnel silicon oxide layer. The metal remaining on the P-type silicon substrate is removed by means of the etch-back technology. This etch-back technology may remove the metal remaining on the P-type silicon substrate using physical methods such as ion etching or chemical methods such as an etch-back liquid. Under the action of light induction, the metal mainly forms a metal electrode on the N-type doped polysilicon layer, and there is only a trace amount of metal in the region outside the N-type doped polysilicon layer, so the action duration of the etch-back technology on the P-type silicon substrate is generally on the millisecond level or the second level, and in this case, the metal on the P-type silicon substrate may be removed without affecting the metal electrode on the N-type doped polysilicon layer 30.

Wherein, when the metal on the P-type silicon substrate 10 is etched back using an etch-back liquid, different etch-back liquids may be selected in accordance with different metals. For example, as for the metal nickel, the optional etch-back liquid may be a mixed acid solution of nitric acid and hydrochloric acid, or a mixed solution formed by nitric acid and ferric chloride; as for the metal copper, the optional etch-back liquid may be a mixed solution of sulfuric acid and hydrogen peroxide; as for the metal silver, the optional etch-back liquid may be a hydrochloric acid solution or an HNOs solution. It is worth noting that when the metal on the P-type silicon substrate 10 is etched back using an etch-back liquid, the etch-back temperature and time, the concentration of the solution, and other parameters may be adjusted according to actual requirements

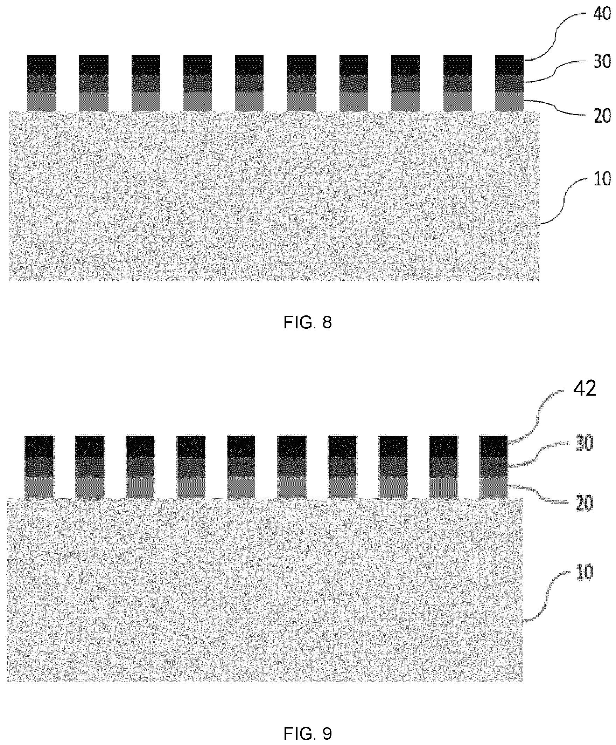

A metallized structure of the local passivated contact emitter as shown in FIG. 8 may be obtained by means of the step S102.

In accordance with the difference in the type of the front metal electrode, the step S102 may be implemented in several different manners.

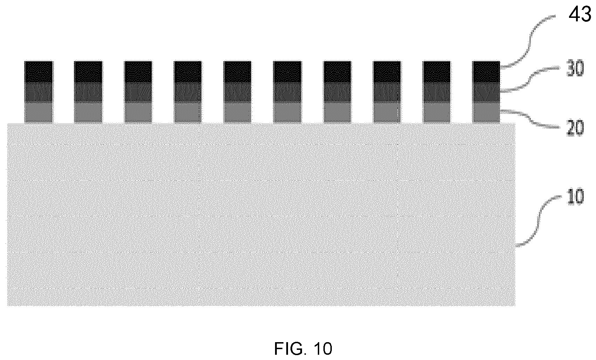

With respect that the front metal electrode is one metal, such as a metal copper electrode or a metal silver electrode, the first implementation scheme of the step S102 may comprise the following steps:
step S2-11: immersing the P-type silicon substrate 10 having the tunnel silicon oxide layer 20 and the N-type doped polysilicon layer 30 locally formed on the front surface into an electroplating solution containing copper ions or silver ions, and irradiating the front surface of the P-type silicon substrate 10 with light for a set duration so as to grow a metal copper electrode or a metal silver electrode on the N-type doped polysilicon layer 30;
step S2-12: removing the metal copper or metal silver on the P-type silicon substrate 10 by etching. The schematic diagrams of the metallized structure of the local passivated contact emitter formed in the first implementation scheme may be as shown in FIG. 9 and FIG. 10. Due to the existence of the N-type doped polysilicon layer 30, the metal copper or metal silver grown by the light-induced electroplating method mainly exists in the N-type doped polysilicon layer 30, and electronization of the metal copper or metal silver grown on the N-type doped polysilicon layer 30 may be directly achieved under the light-induced electroplating method, that is, the metal electrode is directly formed without a metal seed layer or an external electric field. In addition, since there is only a trace amount of the metal copper or metal silver on the P-type silicon substrate 10, the metal copper or metal silver only in a trace amount existing on the P-type silicon substrate 10 may be removed by controlling the etch-back time (this time may be adjusted according to the actual conditions) using the etch-back technology without greatly affecting the metal copper or metal silver grown on the N-type doped polysilicon layer 30.

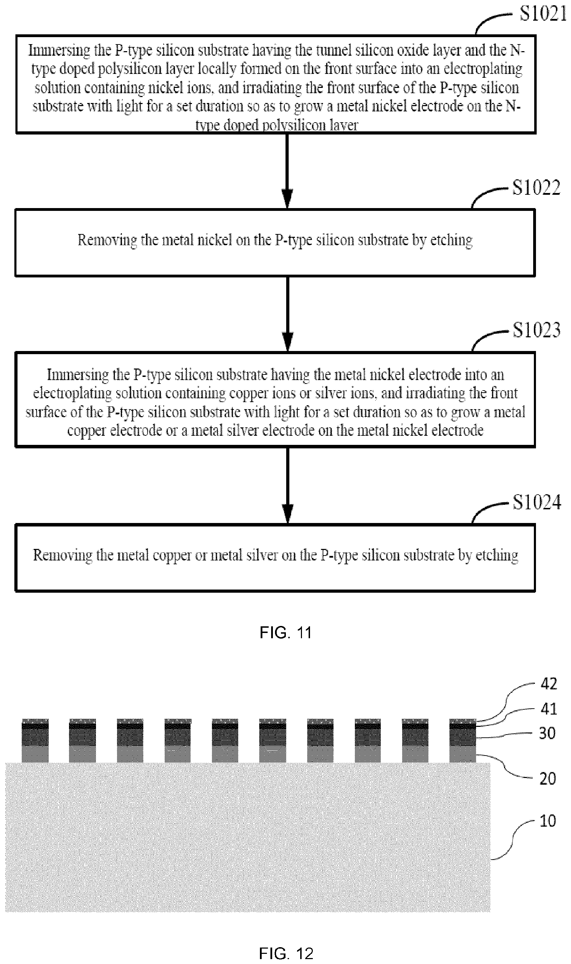

With respect that the front metal electrode is two metals, such as a metal nickel electrode and a metal copper electrode, or a metal nickel electrode and a metal silver electrode, as shown in FIG. 11, the second implementation scheme of the step S102 may comprise the following steps:
step S1021: immersing the P-type silicon substrate having the tunnel silicon oxide layer and the N-type doped polysilicon layer locally formed on the front surface into an electroplating solution containing nickel ions, and irradiating the front surface of the P-type silicon substrate with light for a set duration so as to grow a metal nickel electrode on the N-type doped polysilicon layer;

Generally, the overall electrode height is controlled to be 10-35 µm. The thickness of the metal nickel electrode 41 on the N-type doped polysilicon layer 30 is generally 1-2pm, such as 1 µm, 1.2 µm, 1.3 µm, 1.5 µm, 1.7 µm, 1.9 µm, 2 µm, etc.
step S1022: removing the metal nickel on the P-type silicon substrate by etching;
step S1023: immersing the P-type silicon substrate having the metal nickel electrode into an electroplating solution containing copper ions or silver ions, and irradiating the front surface of the P-type silicon substrate with light for a set duration so as to grow a metal copper electrode or a metal silver electrode on the metal nickel electrode;
wherein, the thickness of the metal copper electrode 42 or the metal silver electrode 43 is generally an arbitrary value in a range of 8-34 µm. In an optional embodiment, the thickness of the metal copper electrode 42 or the metal silver electrode 43 is 10-15 µm.
Step S1024: removing the metal copper or metal silver on the P-type silicon substrate by etching.

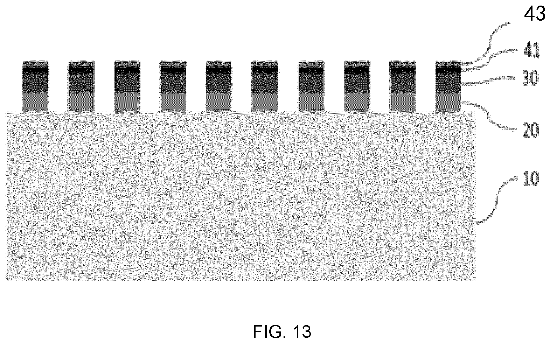

The metallized structure of the local passivated contact emitter obtained by means of the aforesaid steps S1021 to S1024 may be as shown in FIG. 12 or FIG. 13.

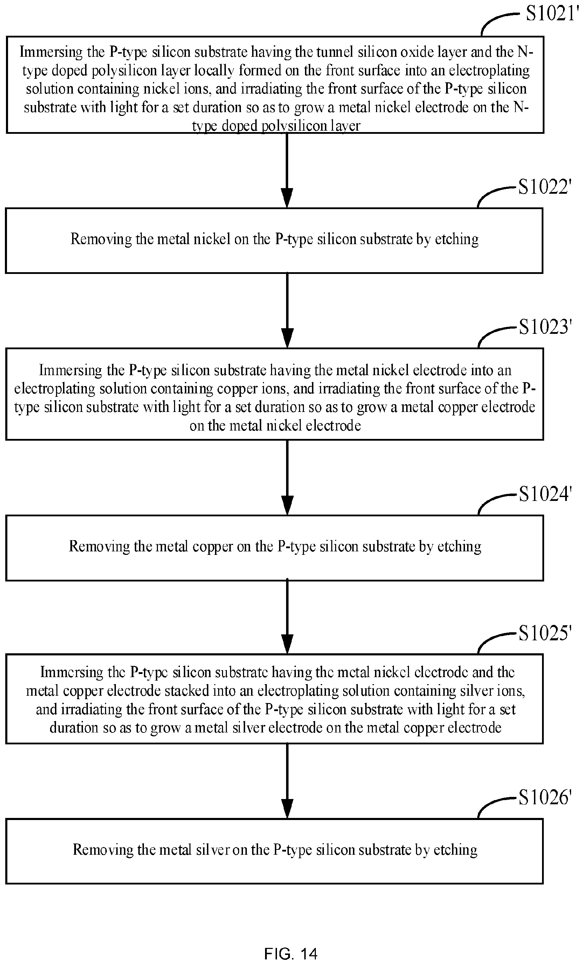

With respect that the front metal electrode is three metals, such as a metal nickel electrode, a metal copper electrode and a metal nickel electrode, as shown in FIG. 14, the third implementation scheme of the step S102 may comprise the following steps:
step S1021': immersing the P-type silicon substrate having the tunnel silicon oxide layer and the N-type doped polysilicon layer locally formed on the front surface into an electroplating solution containing nickel ions, and irradiating the front surface of the P-type silicon substrate with light for a set duration so as to grow a metal nickel electrode on the N-type doped polysilicon layer;
step S1022': removing the metal nickel on the P-type silicon substrate by etching;
step S1023': immersing the P-type silicon substrate having the metal nickel electrode into an electroplating solution containing copper ions, and irradiating the front surface of the P-type silicon substrate with light for a set duration so as to grow a metal copper electrode on the metal nickel electrode;
step S1024': removing the metal copper on the P-type silicon substrate by etching;
step S1025': immersing the P-type silicon substrate having the metal nickel electrode and the metal copper electrode stacked into an electroplating solution containing silver ions, and irradiating the front surface of the P-type silicon substrate with light for a set duration so as to grow a metal silver electrode on the metal copper electrode;
step S1026': removing the metal silver on the P-type silicon substrate by etching.

In the third implementation scheme, the thickness of the metal nickel electrode 41 is generally 1-2 µm, the thickness of the metal copper electrode 42 is generally 6-33µm, and the thickness of the metal silver electrode 43 is generally 1-2 µm. In an optional embodiment, the thickness of the metal copper electrode 42 is generally 10-15 µm.

The thickness of the metal electrode in the metallized structure of the local passivated contact emitter obtained by the third implementation scheme may be Ni/Cu/Ag=2/15/2.

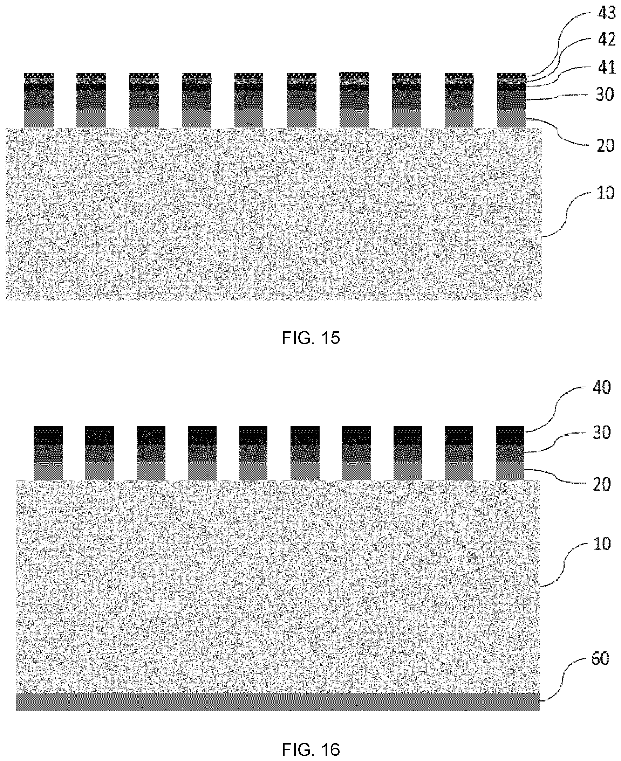

The metallized structure of the local passivated contact emitter obtained by the third implementation scheme may be as shown in FIG. 15.

With respect to the aforesaid second and third implementation schemes, by means of the addition of the metal nickel electrode, the adhesion of the metal copper electrode or metal silver electrode may be effectively increased, and the risk of the fall-off of the metal copper electrode or metal silver electrode may be effectively reduced.

In addition, the reason why an etching back is performed after each light-induced electroplating method is that, on the one hand, since the etching solutions and etching conditions of the respective metals are different, performing a targeted etching back after each light-induced electroplating method may ensure the integrity of the etching back, and meanwhile avoid a damage to the metal electrode that has been grown; on the other hand, if the metal remaining on the P-type silicon substrate is not etched back during the next light-induced electroplating, the remaining metal will form a metal seed layer when the next light-induced electroplating, which accelerates the metal growth rate in this region during the light induction and increases the etching difficulty.

The aforesaid first to third implementation schemes may all make the distance between the front metal electrodes be 100-2000 µm. It is worth noting that the distance between the front metal electrodes may be determined by the distance between the N-type doped polysilicon layers 30 distributed on the front surface of the P-type silicon substrate 10, that is, the distance between the N-type doped polysilicon layers 30 is also an arbitrary value in a range of 100-2000 µm, such as 100 µm, 200µm, 300 µm, 500 µm, 700 µm, 800 µm, 900 µm, 1000 µm, 1200 µm, 1500 µm, 1800µm, and 2000 µm.

One of the aforesaid three implementation schemes may be selected to prepare the metal electrode according to requirements, thereby increasing flexible selectivity and usability of the preparation method for a local passivated contact emitter.

The preparation method for a solar cell provided by the embodiment of the disclosure may grow a metal electrode on a front N-type doped polysilicon layer by immersing the P-type silicon substrate having the tunnel silicon oxide layer and the N-type doped polysilicon layer locally formed on the front surface into an electroplating solution, and irradiating the front surface of the P-type silicon substrate with light for a set duration so as to grow a front metal electrode on the N-type doped polysilicon layer, that is, growing a front metal layer on the front N-type doped polysilicon layer using a light-induced electroplating method for the following reasons:
When a solar cell having a PN function formed on a P-type substrate is placed in the electroplating solution, and when the front N-type doped polysilicon layer is irradiated with light in an emitting region, due to the photovoltaic effect of the solar cell, the light-induced carriers are separated under the action of the built-in electric field. The electrons gather on the N-type doped polysilicon layer and diffuse to its surface, and the electrons are transferred to the metal ions in the electroplating solution. The metal ions are subjected to a reduction reaction on the N-type doped polysilicon layer, so a layer of metal is plated on the N-type doped polysilicon layer to form a metal electrode, that is, the N-type doped polysilicon layer in combination with the growth of the front metal electrode on the front N-type doped polysilicon layer using the light-induced electroplating method may achieve electronization of the front metal electrode in the growing process. A trace amount of metal grown on the P-type silicon substrate not covered by the tunnel silicon oxide layer and the N-type doped polysilicon layer may be removed by means of etching such as etch-back technology, so that the process of preparing the front metal electrode may not require an alignment of the tunnel silicon oxide layer and the N-type doped polysilicon layer that are locally formed, thereby effectively reducing a difficulty in a preparation process of a local passivated contact emitter.

In addition, since the N-type doped polysilicon layer in combination with the growth of the front metal electrode on the front N-type doped polysilicon layer using the light-induced electroplating method may achieve electronization of the front metal electrode in the growing process without an external electric field or an additional metal electrode seed layer, the process difficulty is further reduced, and the preparation method has simple steps and is easily implemented.

In addition, the tunnel silicon oxide layer and the N-type doped polysilicon layer in combination with the growth of the front metal electrode on the front N-type doped polysilicon layer using the light-induced electroplating method may make the width of the front metal electrode be the same as the width of the N-type doped polysilicon layer, and the application of this structure in a solar cell may effectively avoid a loss of a short-circuit current Isc and increase an open circuit voltage Voc, so the application of the local passivated contact emitter obtained by the preparation method for a passivated contact emitter provided by the embodiment of the disclosure to a solar cell may effectively increase the efficiency of the solar cell.

In addition, the front metal grown on the front N-type doped polysilicon layer using the light-induced electroplating method has the same width as the N-type doped polysilicon layer, which may reduce the series resistance of the solar cell where it is located and increase the fill factor of the solar cell, thereby further increasing the efficiency of the solar cell.

In the preparation method for a solar cell provided by the embodiment of the disclosure, in order to further improve the electronization induction of the metal electrode, the steps of the two specific implementation schemes below may be further included.

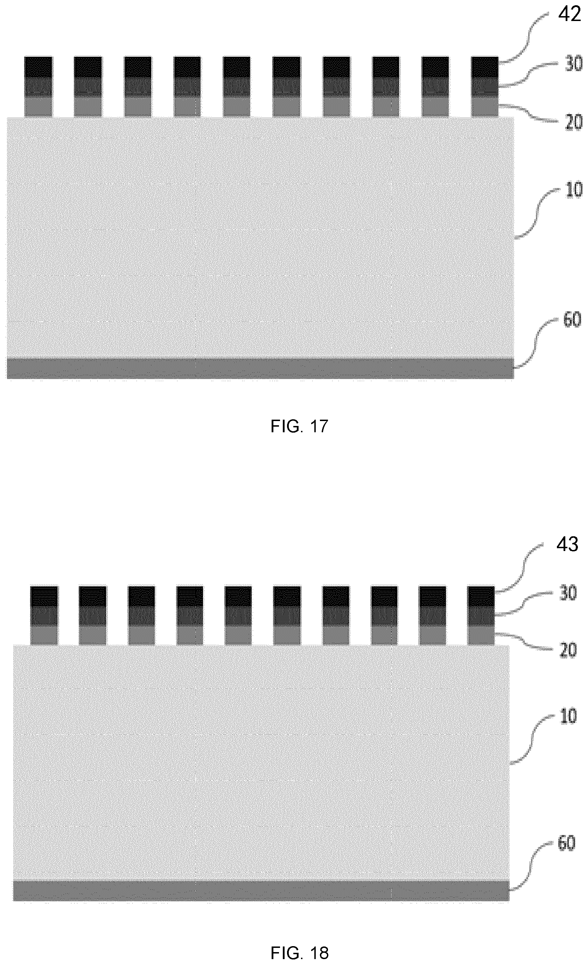

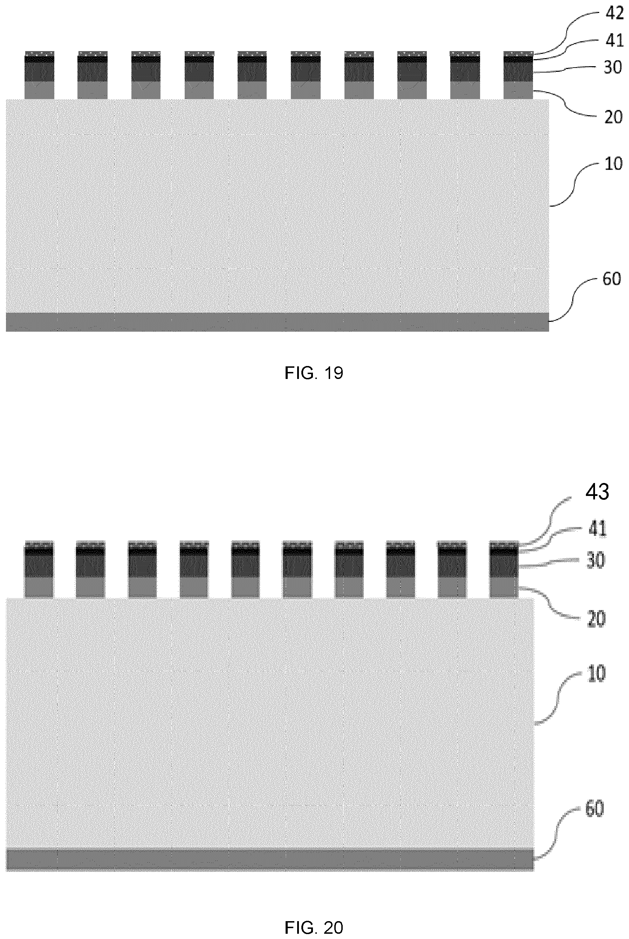

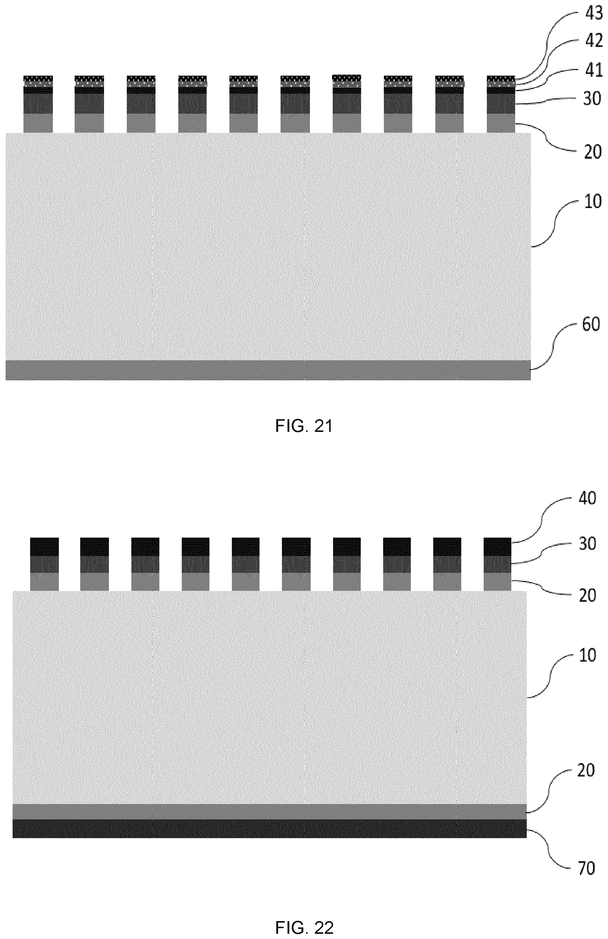

The first specific implementation scheme is as follows: before the aforesaid step S102, the method further comprises forming a P+-type doped layer 60 on the back surface of the P-type silicon substrate 10. The step of forming a P+-type doped layer 60 on the back surface of the P-type silicon substrate 10 may occur before or after the aforesaid step S101. Specifically, the structure shown in FIG. 16 is formed after forming the P+-type doped layer on the back surface of the structure shown in FIG. 8; the structure shown in FIG. 17 is formed after forming the P+-type doped layer on the back surface of the structure shown in FIG. 9; the structure shown in FIG. 18 is formed after forming the P+-type doped layer on the back surface of the structure shown in FIG. 10; the structure shown in FIG. 19 is formed after forming the P+-type doped layer on the back surface of the structure shown in FIG. 12; the structure shown in FIG. 20 is formed after forming the P+-type doped layer on the back surface of the structure shown in FIG. 13; the structure shown in FIG. 21 is formed after forming the P+-type doped layer on the back surface of the structure shown in FIG. 15. It should be noted that the P+-type doped layer represents a P-type doped layer, and the doping concentration thereof is greater than that of the P-type silicon substrate.

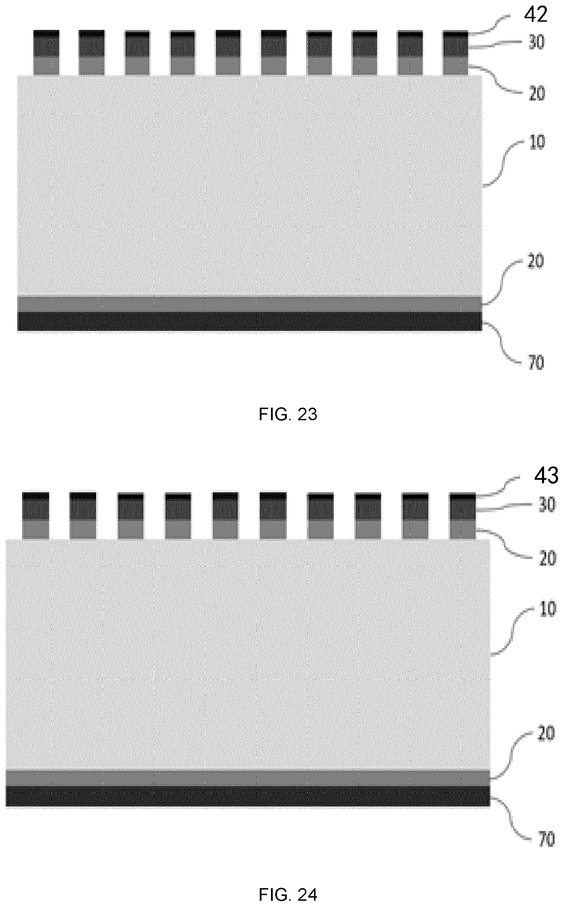

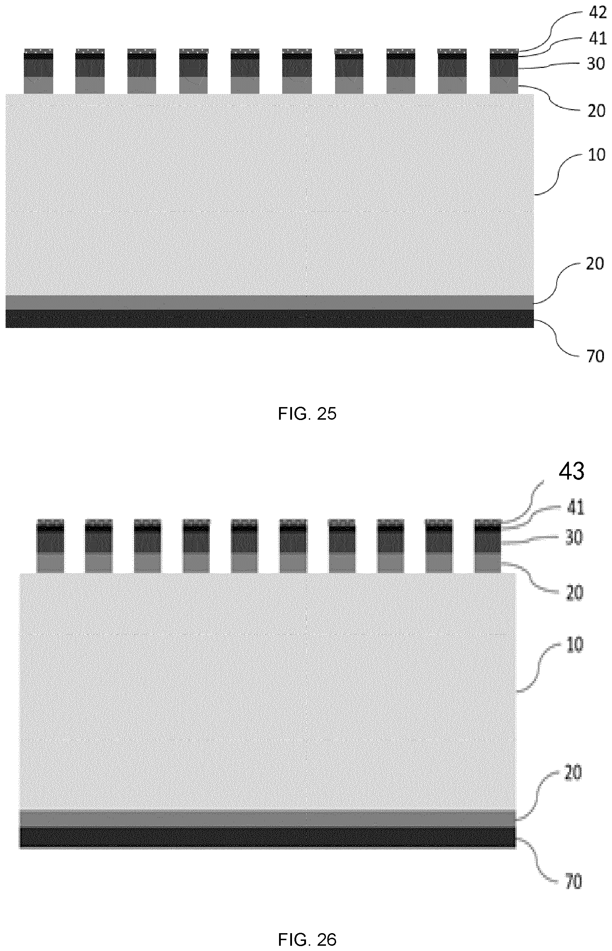

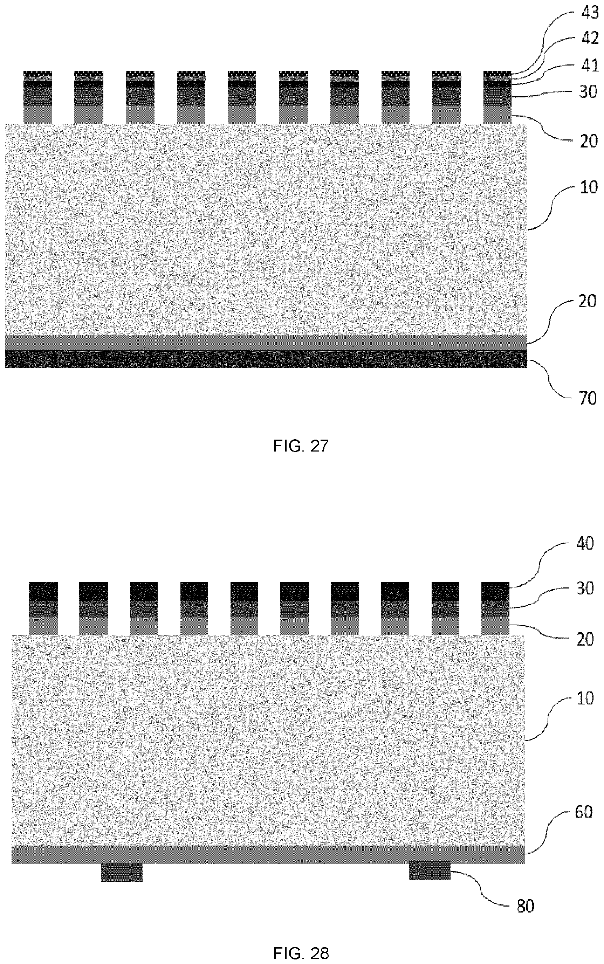

The second specific implementation scheme is as follows: before the aforesaid step S102, the method further comprises sequentially forming the tunnel silicon oxide layer 20 and a P-type doped polysilicon layer 70 on the back surface of the P-type silicon substrate 10. The step of sequentially forming the tunnel silicon oxide layer 20 and a P-type doped polysilicon layer 70 on the back surface of the P-type silicon substrate 10 may occur before or after the aforesaid step S101. Specifically, the structure shown in FIG. 22 is formed after sequentially forming the tunnel silicon oxide layer 20 and the P-type doped polysilicon layer 70 on the back surface of structure shown in FIG. 8; the structure shown in FIG. 23 is formed after sequentially forming the tunnel silicon oxide layer 20 and the P-type doped polysilicon layer 70 on the back surface of structure shown in FIG. 9; the structure shown in FIG. 24 is formed after sequentially forming the tunnel silicon oxide layer 20 and the P-type doped polysilicon layer 70 on the back surface of structure shown in FIG. 10; the structure shown in FIG. 25 is formed after sequentially forming the tunnel silicon oxide layer 20 and the P-type doped polysilicon layer 70 on the back surface of structure shown in FIG. 12; the structure shown in FIG. 26 is formed after sequentially forming the tunnel silicon oxide layer 20 and the P-type doped polysilicon layer 70 on the back surface of structure shown in FIG. 13; the structure shown in FIG. 27 is formed after sequentially forming the tunnel silicon oxide layer 20 and the P-type doped polysilicon layer 70 on the back surface of structure shown in FIG. 15.

The addition of the aforesaid first or second specific implementation scheme before the aforesaid step S102 may effectively improve the electronization induction of the metal electrode, thereby ensuring the efficiency of the solar cell.

In the embodiment of the disclosure, before or after the aforesaid step S102, N-type doping may also be performed in a region outside the local passivated/metallized structure on the front surface of the P-type silicon substrate 10 so as to form an N-type doped junction in the region outside the local passivated/metallized structure on the front surface of the P-type silicon substrate 10. Dopants required to form the N-type doped junction may enter the region outside the local passivated/metallized structure on the front surface of the P-type silicon substrate 10 by means of ion implantation, diffusion, laser doping, and so on.

In addition, the embodiment of the disclosure provides a preparation method for a solar cell that further comprises a step of arranging a back metal electrode. Specifically, a metal electrode is prepared on the surface of the P + type doped layer on the back surface of the P-type silicon substrate, or a back electrode is arranged on the surface of the tunnel silicon oxide layer 20 and the P-type doped polysilicon layer 70 that are sequentially arranged on the back surface of the P-type silicon substrate.

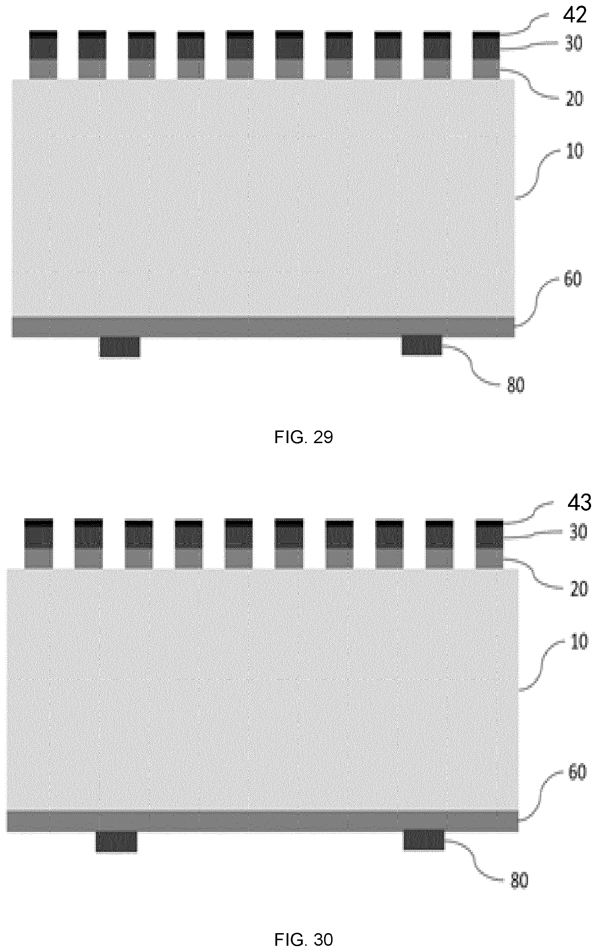

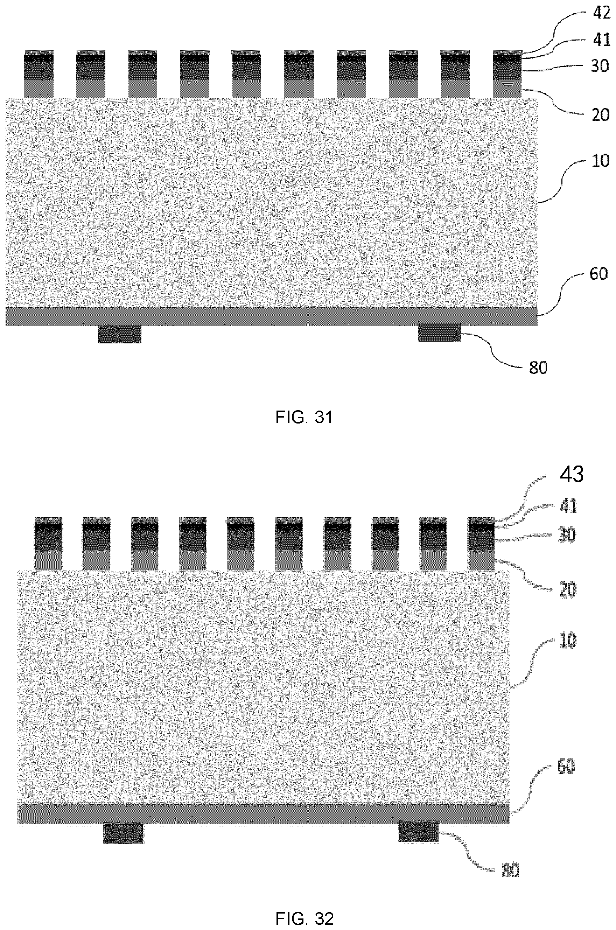

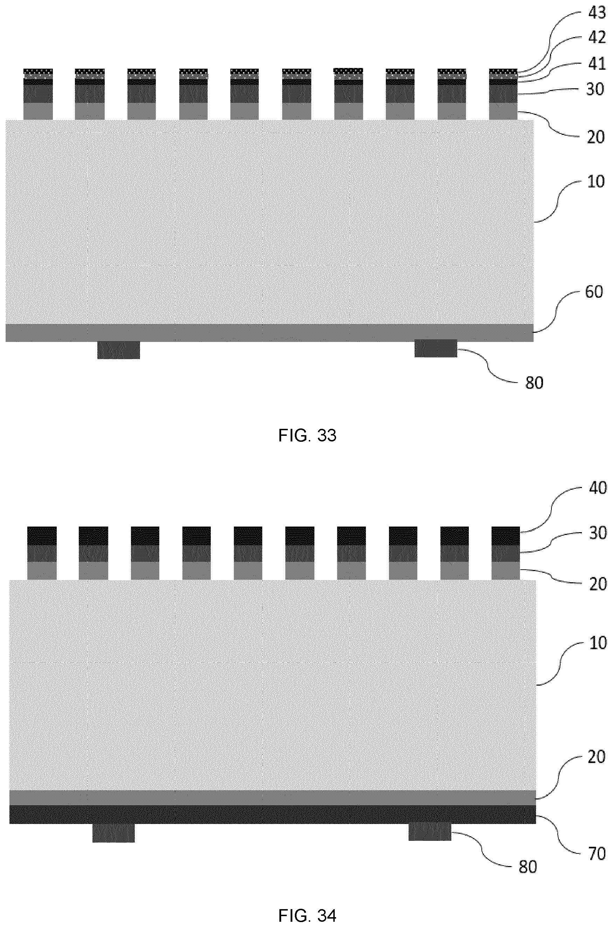

The structure shown in FIG. 28 is obtained by arranging the back metal electrode 80 on the surface of the P+-type doped layer 60 shown in FIG. 16; the structure shown in FIG. 29 is obtained by arranging the back metal electrode 80 on the surface of the P+-type doped layer 60 shown in FIG. 17; the structure shown in FIG. 30 is obtained by arranging the back metal electrode 80 on the surface of the P+-type doped layer 60 shown in FIG. 18; the structure shown in FIG. 31 is obtained by arranging the back metal electrode 80 on the surface of the P+-type doped layer 60 shown in FIG. 19; the structure shown in FIG. 32 is obtained by arranging the back metal electrode 80 on the surface of the P+-type doped layer 60 shown in FIG. 20; the structure shown in FIG. 33 is obtained by arranging the back metal electrode 80 on the surface of the P+-type doped layer 60 shown in FIG. 21.

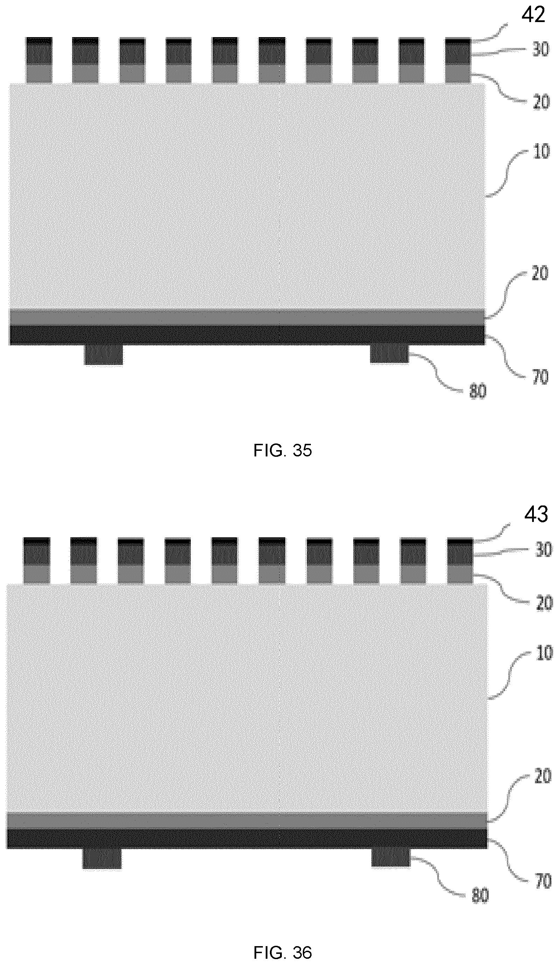

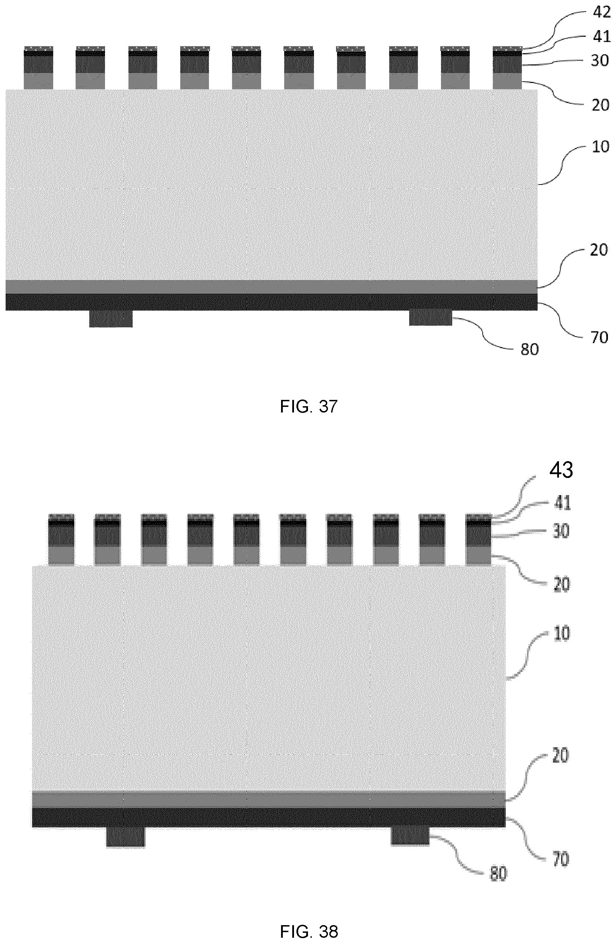

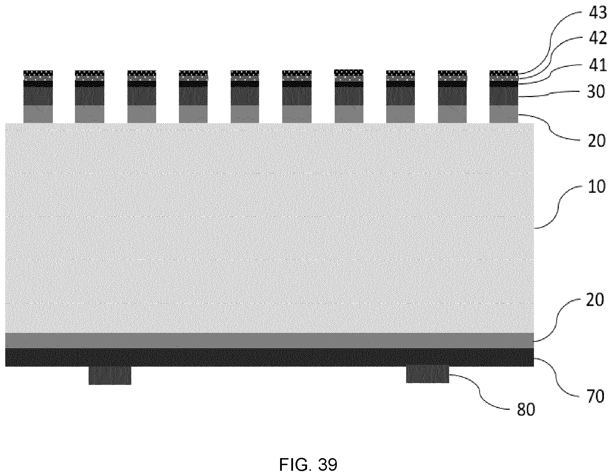

The structure shown in FIG. 34 is obtained by forming the back metal electrode 80 on the surface of the tunnel silicon oxide layer 20 and the P-type doped polysilicon layer 70 that are sequentially formed shown in FIG. 22; the structure shown in FIG. 35 is obtained by forming the back metal electrode 80 on the surface of the tunnel silicon oxide layer 20 and the P-type doped polysilicon layer 70 that are sequentially formed shown in FIG. 23; the structure shown in FIG. 36 is obtained by forming the back metal electrode 80 on the surface of the tunnel silicon oxide layer 20 and the P-type doped polysilicon layer 70 that are sequentially formed shown in FIG. 24; the structure shown in FIG. 37 is obtained by forming the back metal electrode 80 on the surface of the tunnel silicon oxide layer 20 and the P-type doped polysilicon layer 70 that are sequentially formed shown in FIG. 25; the structure shown in FIG. 38 is obtained by forming the back metal electrode 80 on the surface of the tunnel silicon oxide layer 20 and the P-type doped polysilicon layer 70 that are sequentially formed shown in FIG. 26; the structure shown in FIG. 39 is obtained by forming the back metal electrode 80 on the surface of the tunnel silicon oxide layer 20 and the P-type doped polysilicon layer 70 that are sequentially formed shown in FIG. 27.

Another aspect of the disclosure further comprises a solar cell prepared by the above preparation method for a solar cell.

The preparation method for a solar cell provided by the disclosure and the solar cell obtained thereby are described in detail below with several specific embodiments.

### Embodiment 1

Step (A1): Provide a P-type silicon substrate 10.

Step (B1): Grow a tunnel silicon oxide layer 20 with a thickness of 1-2 nm on the front surface of the P-type silicon substrate 10 by a high-temperature thermal oxidation method to obtain the structure as shown in FIG. 2; optionally, the thickness of the tunnel silicon oxide layer 20 is 1.5-2 nm.

Step (C1): Perform boron diffusion and annealing after forming intrinsic polysilicon on the front tunnel silicon oxide layer 20 by means of LPCVD/PVD, and then form an N-type doped polysilicon layer 30 with a thickness of 100-200 nm to obtain the structure as shown in FIG. 3, wherein in an optional embodiment, the thickness of the N-type doped polysilicon layer 30 is between 100-150 nm.

Step (D1): Provide a layer of patterned mask 50 on the N-type doped polysilicon layer 30 to obtain the structure as shown in FIG. 4; the planar pattern of the mask 50 is as shown in FIG. 5. The mask 50 is one of an SiOₓ film, an SiNₓ film and an SiON film.

Step (E1): Remove the N-type doped polysilicon layer 30 in a region not covered by the mask 50 using an alkali solution to obtain the structure as shown in FIG. 6. For example, an alkaline solution where the ratio of KOH to deionized water is 3:11 is selected to perform corrosion for 5 min at a corrosion temperature of 70°C.

Step (F1): Remove the tunnel silicon oxide layer 20 in a region not covered by the mask 50 and the mask 50 using an HF solution to obtain a patterned tunnel silicon oxide layer/N-type doped polysilicon layer with a width of W=5 µm and a distance of L=100 µm to obtain the structure as shown in FIG. 7.

Step (G1): Immerse the structure shown in FIG. 7 obtained in the step (F1) into an electroplating solution, irradiate the front surface of the P-type silicon substrate 10 having the N-type doped polysilicon layer 30 with light, grow a metal electrode 40 on the front N-type doped polysilicon layer 30, and then etch back a trace amount of metal remaining on the front surface of the P-type silicon substrate 10 using a mixed solution of sulfuric acid and hydrogen peroxide to remove the trace amount of metal outside the region of the N-type doped polysilicon layer 30 to obtain the structure as shown in FIG. 8.

### Embodiment 2

Step (A2) is the same as the step (A1) provided in Embodiment 1.

Step (B2): Grow a tunnel silicon oxide layer 20 on the front surface of the P-type silicon substrate 10 by a nitric acid oxidation method.

Step (C2): Perform boron diffusion and annealing after forming intrinsic polysilicon on the front tunnel silicon oxide layer 20 by means of ion implantation to form an N-type doped polysilicon layer 30.

Step (D2) to step (F2) are the same as the step (D1) to the step (F1) provided in Embodiment 1, except that in the step (F2), a patterned tunnel silicon oxide layer/N-type doped polysilicon layer with a width of W=10 µm and a distance of L=500 µm is obtained.

Step (G02) is added after the step (F2).

Step (G02): Form a P+-type doped layer on the back surface of the P-type silicon substrate 10.

Step (G2): Immerse the structure obtained in the step (G02) into an electroplating solution containing nickel ions, irradiate the front surface of the P-type silicon substrate 10 having the N-type doped polysilicon layer 30 with light, grow a metal nickel electrode 41 on the front N-type doped polysilicon layer 30, and etch back a trace amount of nickel on the front surface of the P-type silicon substrate 10 using a mixed acid composed of nitric acid and hydrochloric acid to remove the trace amount of metal nickel on the front surface of the P-type silicon substrate 10; then continue to immerse the P-type silicon substrate 10 on which the metal nickel electrode 41 is grown into an electroplating solution containing copper ions, irradiate the front surface of the P-type silicon substrate 10 having the N-type doped polysilicon layer 30 with light, grow a metal copper electrode 42 on the metal nickel electrode 41, and etch back a trace amount of copper on the front surface of the P-type silicon substrate 10 using a mixed solution of sulfuric acid and hydrogen peroxide to remove the trace amount of metal copper on the front surface of the P-type silicon substrate 10 to obtain the structure as shown in FIG. 19.

### Embodiment 3

Step (A3) to step (G03) in this embodiment are the same as the step (A2) to the step (G02) provided in Embodiment 2.

Step (G3): Immerse the structure obtained in the step (G03) into an electroplating solution containing nickel ions, irradiate the front surface of the P-type silicon substrate 10 having the N-type doped polysilicon layer 30 with light, grow a metal nickel electrode 41 on the front N-type doped polysilicon layer 30, and etch back a trace amount of nickel on the front surface of the P-type silicon substrate 10 using a mixed acid composed of nitric acid and hydrochloric acid to remove the trace amount of metal nickel on the front surface of the P-type silicon substrate 10; then continue to immerse the P-type silicon substrate 10 on which the metal nickel electrode 41 is grown into an electroplating solution containing copper ions, irradiate the front surface of the P-type silicon substrate 10 having the N-type doped polysilicon layer 30 with light, grow a metal copper electrode 42 on the metal nickel electrode 41, and etch back a trace amount of copper on the front surface of the P-type silicon substrate 10 using a mixed solution of sulfuric acid and hydrogen peroxide to remove the trace amount of metal copper on the front surface of the P-type silicon substrate 10; finally immerse the P-type silicon substrate 10 on which the metal nickel electrode 41 is grown into an electroplating solution containing silver ions, irradiate the front surface of the P-type silicon substrate 10 having the N-type doped polysilicon layer 30 with light, grow a metal silver electrode 43 on the metal copper electrode 42, and etch back a trace amount of silver on the front surface of the P-type silicon substrate 10 using an HCl solution or an HNOs solution to remove the trace amount of metal silver on the front surface of the P-type silicon substrate 10 to obtain the structure as shown in FIG. 21.

### Embodiment 4

The respective steps in this embodiment are the same as those in Embodiment 2, except that in step (C4), an N-type doped polysilicon layer with a thickness of 200 µm is formed; and in step (F4), a patterned tunnel silicon oxide layer/N-type doped polysilicon layer with a width of W=40 µm and a distance of L=800 µm is obtained.

### Embodiment 5

Step (A5) to step (F5) in this embodiment are the same as the corresponding steps in Embodiment 3, except that in step (C5), an N-type doped polysilicon layer with a thickness of 150 µm is formed; and in step (F5), a patterned tunnel silicon oxide layer/N-type doped polysilicon layer with a width of W=20 µm and a distance of L=400 µm is obtained.

Step (G05): Form a tunnel silicon oxide layer 20 and a P-type doped polysilicon layer 70 on the back surface of the P-type silicon substrate 10.

Step (G5) is the same as the step (G2) in Embodiment 2 to obtain the structure as shown in FIG. 27.

### Embodiment 6

Step (A6) to step (G6) in this embodiment are the same as the corresponding steps in Embodiment 3, expect that in step (F5), a patterned tunnel silicon oxide layer/N-type doped polysilicon layer with a width of W=50 µm and a distance of L=1000 µm is obtained.

### Embodiment 7

Step (A7) to step (G7) are the same as the step (A1) to the step (G1) in Embodiment 1; and new step (H7) and new step (I7) are added after the step (G7).

Step (H7): Form a P+-type doped layer on the back surface of the P-type silicon substrate 10.

Step (17): Prepare a back metal electrode 80 on the P+-type doped layer on the back surface of the P-type silicon substrate 10 to obtain the structure of the solar cell as shown in FIG. 28.

### Embodiment 8

Step (A8) to step (G8) are the same as the step (A2) to the step (G2) in Embodiment 2; and new step (H8) is added after the step (G8).

Step (H8): Prepare a back metal electrode 80 on the P+-type doped layer on the back surface of the P-type silicon substrate 10 to obtain the structure of the solar cell as shown in FIG. 31.

### Embodiment 9

Step (A9) to step (G9) are the same as the step (A3) to the step (G3) in Embodiment 3; and new step (H9) is added after the step (G9).

Step (H9): Prepare a back metal electrode 80 on the P+-type doped layer on the back surface of the P-type silicon substrate 10 to obtain the structure of the solar cell as shown in FIG. 33.

### Embodiment 10

Step (A10) to step (G10) are the same as the step (A5) to the step (G5) in Embodiment 5; and new step (H10) is added after the step (G10).

Step (H10): Prepare a back metal electrode 80 on the P-type doped polysilicon layer 70 on the back surface of the P-type silicon substrate 10 to obtain the structure of the solar cell as shown in FIG. 39.

The introductions provided by the above steps are only used to help understanding of the method, structure and main idea of the disclosure. Those skilled in the art may also make several improvements and modifications to the invention without departing from the principle of the invention, and these improvements and modifications also fall within the scopes of protection of the claims of the invention.

## Claims

1. A preparation method for a solar cell, comprising:
step 101: locally forming a tunnel silicon oxide layer (20) and an N-type doped polysilicon layer (30) on a front surface of a P-type silicon substrate (10), wherein the N-type doped polysilicon layer (30) is stacked on the tunnel silicon oxide layer (20);
step 102: immersing the P-type silicon substrate (10) having the tunnel silicon oxide layer (20) and the N-type doped polysilicon layer (30) locally formed on the front surface into an electroplating solution, irradiating the front surface of the P-type silicon substrate (10) with light for a set duration so as to grow a front metal electrode (40) on the N-type doped polysilicon layer (30), and removing a metal remaining on the front surface of the P-type silicon substrate (10) by etching, wherein the width of the front metal electrode is the same as the width of the N-type doped polysilicon layer (30).

2. The preparation method for a solar cell of claim 1, wherein the step 101 comprises:
step 1-1: growing an entire tunnel silicon oxide layer (20) on the front surface of the P-type silicon substrate (10);
step 1-2: forming an entire N-type doped polysilicon layer (30) on the entire tunnel silicon oxide layer (20) grown on the front surface;
step 1-3: arranging a patterned mask (50) on the entire N-type doped polysilicon layer (30);
step 1-4: removing the N-type doped polysilicon layer (30) in a region not covered by the mask (50) using an alkali solution;
step 1-5: removing the tunnel silicon oxide layer (20) in a region not covered by the mask (50), and then removing the mask (50) using an acid solution.

3. The preparation method for a solar cell of claim 2, wherein
the mask (50) in the step 1-3 includes: any one of an SiOₓ film, an SiNₓ film and an SiON film.

4. The preparation method for a solar cell of claim 1, wherein
the widths of the tunnel silicon oxide layer (20) and the N-type doped polysilicon layer (30) formed in the step 101 are 5-50 µm.

5. The preparation method for a solar cell of claim 1, wherein before the step 102, the method further comprises:
forming a P+-type doped layer (60) on the back surface of the P-type silicon substrate (10).

6. The preparation method for a solar cell of claim 1, wherein before the step 102, the method further comprises:
sequentially forming the tunnel silicon oxide layer (20) and a P-type doped polysilicon layer (70) on the back surface of the P-type silicon substrate (10).

7. The preparation method for a solar cell of any of claims 1 and 5-6, wherein the step 102 comprises:
step 2-11: immersing the P-type silicon substrate (10) having the tunnel silicon oxide layer (20) and the N-type doped polysilicon layer (30) locally formed on the front surface into an electroplating solution containing copper ions or silver ions, and irradiating the front surface of the P-type silicon substrate (10) with light for a set duration so as to grow a metal copper electrode (42) or a metal silver electrode (43) on the N-type doped polysilicon layer (30);
step 2-12: removing the metal copper or silver remaining on the P-type silicon substrate (10) by etching.

8. The preparation method for a solar cell of any of claims 1 and 5-6, wherein the step 102 comprises:
step 1021: immersing the P-type silicon substrate (10) having the tunnel silicon oxide layer (20) and the N-type doped polysilicon layer (30) locally formed on the front surface into an electroplating solution containing nickel ions, and irradiating the front surface of the P-type silicon substrate (10) with light for a set duration so as to grow a metal nickel electrode (41) on the N-type doped polysilicon layer (30);
step 1022: removing the metal nickel remaining on the P-type silicon substrate (10) by etching;
step 1023: immersing the P-type silicon substrate (10) having the metal nickel electrode (41) into an electroplating solution containing copper ions or silver ions, and irradiating the front surface of the P-type silicon substrate (10) with light for a set duration so as to grow a metal copper electrode (42) or a metal silver electrode (43) on the metal nickel electrode (41);
step 1024: removing the metal copper or metal silver remaining on the P-type silicon substrate (10) by etching.

9. The preparation method for a solar cell of any of claims 1 and 5-6, wherein the step 102 comprises:
step S1021': immersing the P-type silicon substrate (10) having the tunnel silicon oxide layer (20) and the N-type doped polysilicon layer (30) locally formed on the front surface into an electroplating solution containing nickel ions, and irradiating the front surface of the P-type silicon substrate (10) with light for a set duration so as to grow a metal nickel electrode (41) on the N-type doped polysilicon layer (30);
step S1022': removing the metal nickel remaining on the P-type silicon substrate (10) by etching;
step S1023': immersing the P-type silicon substrate (10) having the metal nickel electrode (41) into an electroplating solution containing copper ions, and irradiating the front surface of the P-type silicon substrate (10) with light for a set duration so as to grow a metal copper electrode (42) on the metal nickel electrode (41);
step S1024': removing the metal copper remaining on the P-type silicon substrate (10) by etching;
step S1025': immersing the P-type silicon substrate (10) having the metal nickel electrode (41) and the metal copper electrode (42) stacked into an electroplating solution containing silver ions, and irradiating the front surface of the P-type silicon substrate (10) with light for a set duration so as to grow a metal silver electrode (43) on the metal copper electrode (42);
step S1026': removing the metal silver remaining on the P-type silicon substrate (10) by etching.

10. A solar cell, prepared by the preparation method of any of claims 1-9.
